# EUROPEAN PATENT APPLICATION

(11) **EP 2 624 000 A1**
(43) Date of publication of application: **07.08.2013**
(21) Application number: 10857801.4
(22) Date of filing: 27.09.2010
(51) Int. Cl.: G01R 31/28, H01L 21/822, H01L 27/04

(54) **INTEGRATED CIRCUIT**

(71) Applicant: Fujitsu Limited, Kawasaki-shi, Kanagawa 211-8588 (JP)
(72) Inventor: ITOZAWA, Shintaro, Kanagawa 211-8588 (JP); NISHIO, Masahiro, Kanagawa 211-8588 (JP); NAKAYAMA, Hiroshi, Kanagawa 211-8588 (JP); ICHIMIYA, Junji, Kanagawa 211-8588 (JP); TAKAHASHI, Jin, Kanagawa 211-8588 (JP)
(74) Representative: Ward, James Norman
(86) International application number: PCT/JP2010/066709
(87) International publication number: WO 2012/042586

(57) **Abstract**

Object

An objective is to provide an integrated circuit capable of performing an operation check test for a combination circuit present in sections that are not connected by a scan chain.

Solution Means

An integrated circuit includes a first signal processing circuit in which a plurality of first combination circuits and a plurality of scan FFs (Flip Flop) are connected in an order of a scan FF, a first combination circuit, and a scan FF; a second signal processing circuit including a second combination circuit different from the first combination circuit; a first selection circuit configured to select data from a scan FF on an input side of one of the plurality of first combination circuits or data from an input terminal of the second signal processing circuit, and to output the selected data to the second combination circuit; and a second selection circuit configured to select data from another one of the plurality of first combination circuits different from the one of the plurality of first combination circuits or data from the second combination circuit, and to output the selected data to the scan FF on an output side of the another one of the plurality of first combination circuits.

## Description

### TECHNICAL FIELD

The present invention is related to an integrated circuit.

### BACKGROUND ART

Conventionally, there is a boundary scan circuit that performs a boundary scan test by scanning an input output interface of a large scale integrated circuit (LSI) based on the JTAG (Joint Test Action Group) specification of IEEE 1149.1 (The Institute of Electrical and Electronics Engineers, Inc. 1149.1). Such a boundary scan circuit is included in an integrated circuit.
Patent Document 1: Japanese Laid-Open
   Patent Publication No. 2002-236145
Patent Document 2: Japanese Laid-Open
   Patent Publication No. H11-281710

A conventional integrated circuit includes a scan chain for performing a scan test on an internal circuit of LSI, in addition to a boundary scan circuit for performing a boundary scan test of scanning the input output interface of LSI. The scan test is an operation check test of a combination circuit included in an integrated circuit. A scan chain is a circuit for a scan test of connecting, in a chain, scan-in terminals and scan-out terminals of a scan FF (Flip Flop) provided on input sides and output sides of many combination circuits included in an integrated circuit.

In a scan test, each scan FF is made to hold test data that is a value of either 1 or 0, the test data is input from the scan FF of the input side, and is output to the scan FF of the output side via result data that is a processing result of the combination circuit. Then, the output data that is a processing result of each combination circuit held in the scan FF is extracted by scanning and compared with an expectation value, to check whether the operation of each combination circuit is properly performed.

A scan test performed by using such a scan chain may be performed for sections where it is possible to output the output data of a combination circuit with respect to input test data, through a combination circuit between the scan FF of the input side and the scan FF of the output side, by connecting to a scan chain. However, it is not possible to perform the scan test for sections that are not connected to the scan chain.

Thus, there is a problem that it is not possible to perform an operation check for a combination circuit present in a section that is not connected by a scan chain.

The objective of the present invention is to provide an integrated circuit capable of performing an operation check test for a combination circuit present in sections that are not connected by a scan chain.

### MEANS TO SOLVE THE PROBLEMS

An integrated circuit according to an embodiment of the present invention includes a first signal processing circuit in which a plurality of first combination circuits and a plurality of scan FFs (Flip Flop) are connected in an order of a scan FF, a first combination circuit, and a scan FF; a second signal processing circuit including a second combination circuit different from the first combination circuit; a first selection circuit configured to select data from a scan FF on an input side of one of the plurality of first combination circuits or data from an input terminal of the second signal processing circuit, and to output the selected data to the second combination circuit; and a second selection circuit configured to select data from another one of the plurality of first combination circuits different from the one of the plurality of first combination circuits or data from the second combination circuit, and to output the selected data to the scan FF on an output side of the another one of the plurality of first combination circuits.

### EFFECTS OF THE INVENTION

An integrated circuit is provided, which is capable of performing an operation check test for a combination circuit present in sections that are not connected by a scan chain.

### BRIEF DESCRIPTION OF DRAWINGS

FIG. 1 illustrates a scan chain included in an integrated circuit of a comparative example.
FIG. 2 illustrates a circuit of an input circuit 141 of an LSI 1 of a comparative example.
FIG. 3 illustrates a circuit configuration of a scan FF 201 included in the LSI 1 of the comparative example.
FIG. 4 illustrates an information processing device including an integrated circuit according to a first embodiment.
FIG. 5 is a block diagram of the LSI 100 according to the first embodiment.
FIG. 6 is a partial enlargement of the LSI 100 according to the first embodiment.
FIG. 7 illustrates a circuit of an input circuit 410 of the LSI 100.
FIG. 8 illustrates a circuit of an output circuit 420 of the LSI 100.
FIG. 9A indicates a timing chart indicating the timings of various signals and various clocks when performing an operation check test of a combination circuit 110 of the LSI 100 according to the first embodiment.
FIG. 9B indicates the timing chart indicating the timings of various signals and various clocks when performing an operation check test of a combination circuit 110 of the LSI 100 according to the first embodiment.
FIG. 10 is a partial enlargement of a LSI 200 according to a second embodiment.

### MODES FOR CARRYING OUT THE INVENTION

In the following, a description is given of embodiments to which an integrated circuit and an information processing device of the present invention are applied.

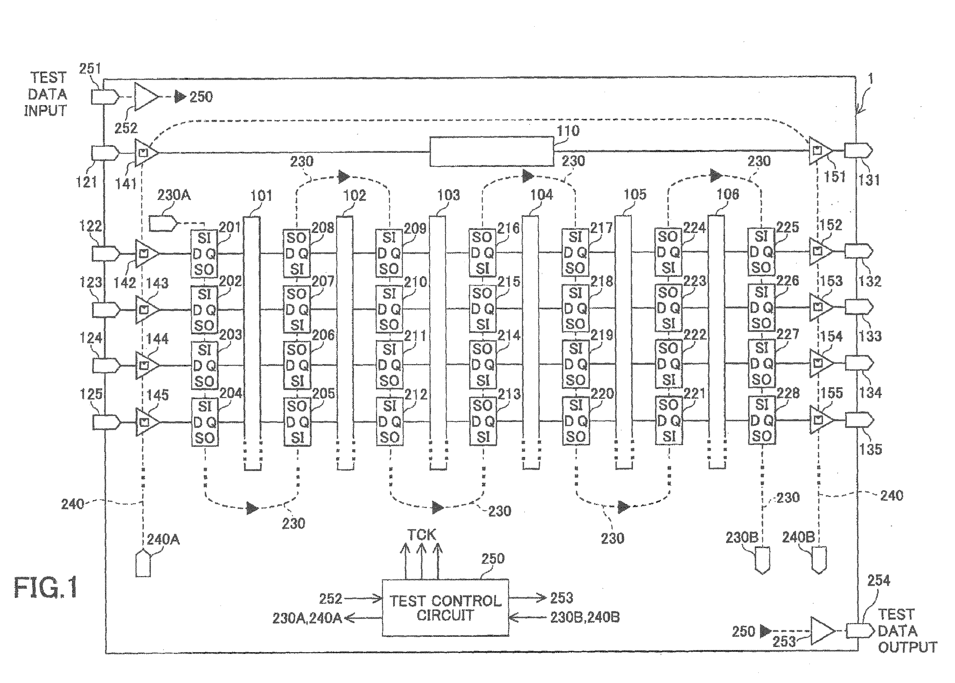

Before describing an integrated circuit and an information processing device according to the present embodiment, a description is given of problems of an integrated circuit of a comparative example, with reference to FIGS. 1 through 3.

FIG. 1 illustrates a scan chain included in an integrated circuit of a comparative example.

A large scale integrated circuit (hereinafter, "LSI") 1 includes combination circuits 101 through 106, a combination circuit 110, input terminals 121 through 125, output terminals 131 through 135, input circuits 141 through 145, and output circuits 151 through 155.

As a matter of convenience, in FIG. 1, there are six combination circuits 101 through 106 and one combination circuit 110; however, the LSI 1 may include more combination circuits 101 through 106 and combination circuits 110.

Furthermore, the LSI 1 may include more input terminals 121 through 125, output terminals 131 through 135, input circuits 141 through 145, and output circuits 151 through 155.

Furthermore, the LSI 1 further includes scan FFs 201 through 228, a scan chain 230, a boundary scan chain 240, a test control circuit 250, a test data input terminal 251, an input circuit 252, an output circuit 253, and a test data output terminal 254.

As a matter of convenience, in FIG. 1, there are 28 scan FFs 201 through 228; however, the LSI 1 may include more scan FFs.

As for the scan chain 230, the boundary scan chain 240, the test control circuit 250, the test data input terminal 251, the input circuit 252, the output circuit 253, and the test data output terminal 254, the LSI 1 is to include at least one of each of these elements.

The LSI 1 in FIG. 1 is used as, for example, a memory buffer connected between a memory controller connected to a CPU (Central Processing Unit) and a main memory.

The combination circuits 101 through 106 are circuits of the LSI 1 for which the user may freely design the logic, and are circuits by which output data may be obtained by an operation of combination circuits with respect to input data. To the input terminals of the combination circuits 101 through 106, data output terminals Q of the scan FFs 201 through 224 are connected. Furthermore, to the output terminals of the combination circuits 101 through 106, data input terminals D of the scan FFs 205 through 228 are connected.

The combination circuits 101 through 106 respectively process data that is input from the data output terminals Q of the scan FFs 201 through 224 positioned on the left side in FIG. 1 of the respective combination circuits 101 through 106 and output the data to data input terminals D of the scan FFs 205 through 228 positioned on the right side in FIG. 1 of the respective combination circuits 101 through 106. For example, the combination circuit 101 processes the data input from the data output terminal Q of the scan FF 201, and inputs the data to the data input terminal D of the scan FF 208.

Similar to the combination circuits 101 through 106, the combination circuit 110 is a circuit of the LSI 1 for which the user may freely design the logic, and is a circuit by which output data may be obtained by an operation of combination circuits with respect to input data. The combination circuit 110 is different from the combination circuits 101 through 106 in that each of the FFs of the input side and output side of the combination circuit 110 is not a scan FF provided with a scan terminal and having a scan function, but is a non-scan FF without a scan terminal or a scan function. On the input side of the combination circuit 110, the input terminal 121 is connected via the input circuit 141. On the output side of the combination circuit 110, the output terminal 131 is connected via the output circuit 151.

The input terminals 121 through 125 are input terminals of the LSI 1. For example, when the LSI 1 is used as a memory buffer, various kinds of data are input to the LSI 1 from the memory controller or the main memory via the input terminals 121 through 125.

The output terminals 131 through 135 are output terminals of the LSI 1. For example, when the LSI 1 is used as a memory buffer, various kinds of data are output from the LSI 1 to the memory controller or the main memory via the output terminals 131 through 135.

The input circuits 141 through 145 are circuits for outputting data that is input via the input terminals 121 through 125 to the combination circuit 110 and the scan FFs 201 through 204. The input circuits 141 through 145 include a boundary scan circuit, and the boundary scan chain 240 is connected. The input circuits 141 through 145 have the same function.

For example, to the input circuits 141 through 145, output terminals of another LSI are connected via wirings formed on a substrate on which the LSI 1 is mounted.

The output circuits 151 through 155 (see FIG. 1) are circuits that output data output from the combination circuit 110 and the scan FFs 225 through 228, to the output terminals 131 through 135. The output circuits 151 through 155 include a boundary scan circuit, and the boundary scan chain 240 is connected.

For example, to the output circuits 151 through 155, input terminals of another LSI are connected via wirings formed on a substrate on which the LSI 1 is mounted.

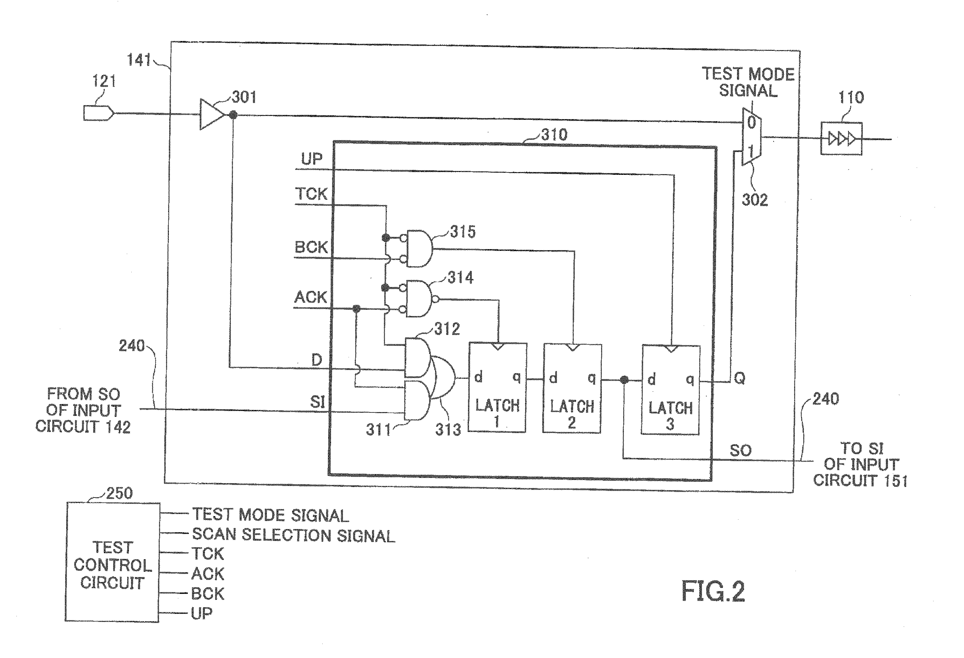

Circuit configurations of the input circuits 141 through 145 and the output circuits 151 through 155 are described below with reference to FIG. 2.

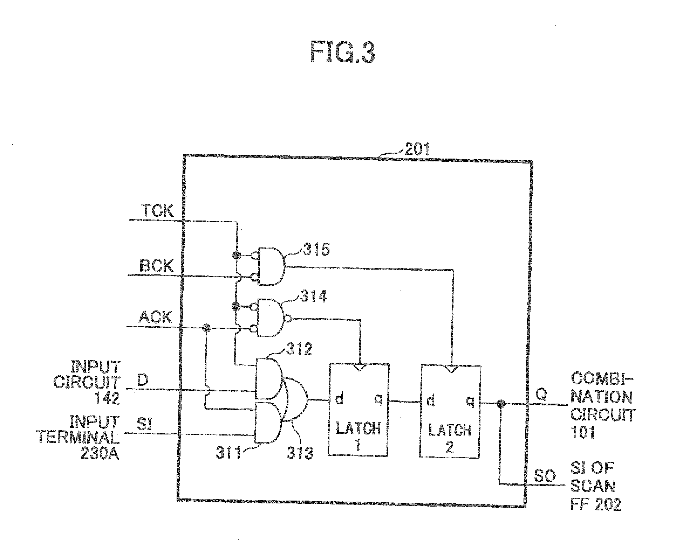

The scan FFs 201 through 228 have scan in terminals SI (Scan In) and scan out terminals SO (Scan Out), which are connected by the scan chain 230. The scan FFs 201 through 228 are provided for performing a scan test on the combination circuits 101 through 106 included inside the LSI 1. In each of the scan FFs 201 through 224, it is possible to set test data used for a scan test via the scan chain 230. The test data that is processed by the combination circuits 101 through 106 in a scan test and input to the scan FFs 205 through 228 may be extracted via the scan chain 230. Circuit configurations of the scan FFs 201 through 228 are described below with reference to FIG. 3.

The scan chain 230 includes an input terminal 230A and an output terminal 230B. The scan chain 230 connects, in a chain, the scan in terminals SI and the scan out terminals SO of the scan FFs 201 through 228 that are interposed between the input terminal 230A and the output terminal 230B. The scan chain 230 is provided for performing a scan test to check the operations of each of the combination circuits 101 through 106.

The input terminal 230A of the scan chain 230 is connected to the test control circuit 250, and test data for a scan test is input from the test control circuit 250 to the input terminal 230A. Furthermore, the output terminal 230B of the scan chain 230 is connected to the test control circuit 250, and result data expressing results of a scan test is input to the test control circuit 250.

The boundary scan chain 240 includes an input terminal 240A and an output terminal 240B. The boundary scan chain 240 connects, in a chain, the scan in terminals SI and the scan out terminals SO of the input circuits 141 through 145 and the output circuits 151 through 155 that are interposed between the input terminal 240A and the output terminal 240B. The boundary scan chain 240 is provided for performing a boundary scan test to test the connection state of the input circuits 141 through 145 and the output circuits 151 through 155.

The input terminal 240A of the boundary scan chain 240 is connected to the test control circuit 250, and test data for the boundary test is input from the test control circuit 250 to the input terminal 240A. Furthermore, the output terminal 240B of the boundary scan chain 240 is connected to the test control circuit 250, and inputs result data expressing results of the boundary scan test to the test control circuit 250.

The test control circuit 250 is a control circuit such as TAP_CON (Test Access Port Controller) for controlling a boundary scan test and a scan test, and includes a state machine in compliance with the JTAG specification. When performing the boundary scan test, the test control circuit 250 inputs the test data for the boundary scan test input from an external test device such as an LSI tester to the boundary scan chain 240, and inputs a test clock, etc., defined by the JTAG specification in the input circuits 141 through 145 and the output circuits 151 through 155.

Furthermore, when performing the scan test, the test control circuit 250 inputs data for the scan test input from an external test device in the scan chain 230, and inputs a test clock, etc., defined by the JTAG specification in the scan FFs 201 through 228.

The result data expressing results of the boundary scan test and the result data expressing results of the scan test are transferred from the test control circuit 250 to an external test device such as an LSI tester, and the external test device determines whether the result data is indicating a proper result.

The test data input terminal 251 is a terminal connected to the external test device when performing a scan test and a boundary scan test. Data for the boundary scan test and data for the scan test are input to the test control circuit 250 from the external test device via the test data input terminal 251.

The input circuit 252 inputs, in the test control circuit 250, data for a test that is input from the external test device via the test data input terminal 251.

The output circuit 253 is connected to the test control circuit 250, and transmits result data expressing results of the scan test and the boundary scan test, to the test data output terminal 254.

The test data output terminal 254 is connected to the external test device, and is a terminal for outputting, to the external test device, result data expressing test results to be transmitted from the test control circuit 250 via the output circuit 253.

The scan chain 230, the boundary scan chain 240, and the test control circuit 250 are connected to each other via a selector, a decoder, a register, etc. (not illustrated).

With reference to FIGS. 2 and 3, a simple description is given of the circuit configurations of the input circuits 141 through 145, the output circuits 151 through 155, and the scan FFs 201 through 228, and the boundary scan test and the scan test.

First, with reference to FIG. 2, a description is given of the circuit configurations of the input circuits 141 through 145 and the output circuits 151 through 155, and the boundary scan test.

The input circuits 141 through 145 and the output circuits 151 through 155 have the same function, and therefore a description given of the input circuit 141.

FIG. 2 illustrates a circuit of the input circuit 141 of the LSI 1 of a comparative example.

The input circuit 141 includes an input buffer 301, a selector 302, and a boundary scan circuit 310.

The input buffer 301 is provided for transmitting input data input from another LSI via wirings connected to the input terminal 121.

The selector 302 selects a signal from either one of the input buffer 301 or the boundary scan circuit 310 based on a test mode signal input from the test control circuit 250, and outputs the selected signal. To the output terminal of the selector 302, the combination circuit 110 is connected.

The boundary scan circuit 310 includes AND (logical product) circuits 311, 312, an OR (logical sum) circuit 313, AND circuits 314, 315, a latch 1, a latch 2, and a latch 3.

The AND circuits 311, 312 and the OR circuit 313 are cascade-connected, and the output terminal of the OR circuit 313 is connected to a data input terminal d of the latch 1.

A data output terminal q of the latch 1 is connected to a data input terminal d of the latch 2, and a data output terminal q of the latch 2 is connected to the data input terminal d of the latch 3. A data output terminal q of the latch 3 is connected to one input terminal of the selector 302. A data output terminal q of the latch 3 is a data output terminal Q of the boundary scan circuit 310.

The data output terminal q of the latch 2 is connected to a scan in terminal S1 of the boundary scan circuit 310 included in the output circuit 151 via the boundary scan chain 240.

An output terminal of the AND circuit 314 is connected to a clock input terminal of the latch 1, and an output terminal of the AND circuit 315 is connected to a clock input terminal of the latch 2.

Here, inverters are connected to the two input terminals of the AND circuit 314, which invert the logic of input signals and input the signals in the AND circuit. Furthermore, an inverter is connected to the output terminal of the AND circuit 314, which inverts the logic of a signal output from the AND circuit and outputs the signal. Therefore, the AND circuit 314 is logically equal to the OR (logical sum) circuit.

Furthermore, inverters are connected to the two input terminals of the AND circuit 315, which invert the logic of input signals and input the signals in the AND circuit. Therefore, the AND circuit 315 is logically equal to a NOR (negative logical sum) circuit.

To one input terminal of the AND circuit 311, data for the boundary test is input via the boundary scan chain 240 from the scan out terminal SO of the input circuit 142. To the other input terminal of the AND circuit 311, an A clock signal ACK is input from the test control circuit 250. The input terminal to which data for the boundary scan test is input is the scan in terminal SI of the boundary scan circuit 310.

To one input terminal of the AND circuit 312, a data signal is input via the input buffer 301, and to the other input terminal of the AND circuit 312, a test clock TCK is input from the test control circuit 250. The input terminal to which a data signal is input is the data input terminal D of the boundary scan circuit 310.

To one input terminal of the AND circuit 314, an A clock ACK which is a shift clock is inverted and input from the test control circuit 250, and to the other input terminal of the AND circuit 314, a test clock TCK is inverted and input from the test control circuit 250. Output of the AND circuit 314 is inverted and input to the latch 1 as a clock signal.

To one input terminal of the AND circuit 315, a B clock BCK which is a shift clock is inverted and input from the test control circuit 250, and to the other input terminal of the AND circuit 315, a test clock TCK is inverted and input from the test control circuit 250. Output of the AND circuit 315 is input to the latch 2 as a clock signal.

To the input terminal of the latch 3, an update signal UP for outputting scan data to the combination circuit 110 that performs system operation is input, by applying scan data held by the latch 2 to the latch 3 from the test control circuit 250.

At the time of a regular system operation where a boundary scan test is not performed, a test mode signal input from the test control circuit 250 is "0", and the selector 302 connects the input buffer 301 and the combination circuit 110. Accordingly, input data input from the input terminal 121 via the input buffer 301 is transferred to the combination circuit 110. Then, as a result, input data is processed at the combination circuit 110.

In order to perform a boundary scan test, the test control circuit 250 sets the test mode signal to "1". Then, the selector 302 switches the input source of the data to the data output terminal Q of the boundary scan circuit 310.

Furthermore, the test control circuit 250 outputs the A clock ACK, the B clock BCK, the test clock TCK, and the update signal UP, at predetermined timings.

Then, to the boundary scan circuit 310, data for the boundary scan test is input to the scan in terminal SI, and the A clock ACK, the B clock BCK, the test clock TCK, and the update signal UP are input at predetermined timings. Accordingly, the data input to the data input terminal D is input via the latch 1 and the latch 2 from the scan out terminal SO to the scan in terminal SI of the output circuit 151. Furthermore, the data output terminal q of the latch 3 is connected to one input terminal of the selector 302. When an update signal UP is input to the clock input terminal of the latch 3, the scan data held by the latch 2 is applied to the latch 3, and scan data is output to the combination circuit 110 via the selector 302.

Here, a description has been given of the circuit configuration of the input circuit 141, but the input circuits 142 through 145 and the output circuits 151 through 155 each include the boundary scan circuit 310 similar to that of the input circuit 141.

As described above, the scan in terminal SI and the scan out terminal SO of the boundary scan circuit 310 of the input circuits 141 through 145 and the output circuits 151 through 155 are connected by the boundary scan chain 240.

The LSI 1 performs a boundary scan test by connecting wirings and another LSI to the input terminals 121 through 125 and the output terminals 131 through 135 illustrated in FIG. 1, and sets data for the boundary scan test in the input circuits 141 through 145 and the output circuits 151 through 155 via the boundary scan chain 240.

Next, with reference to FIG. 3, a description is given of the circuit configuration of the scan FFs 201 through 224 and the scan test.

The scan FFs 201 through 228 have the same circuit configuration, and therefore a description is given of the circuit configuration of the scan FF 201.

FIG. 3 illustrates a circuit configuration of the scan FF 201 included in the LSI 1 of the comparative example.

As illustrated in FIG. 3, the scan FF 201 includes AND circuits 311, 312, an OR circuit 313, AND circuits 314, 315, a latch 1, and a latch 2.

The AND circuits 311, 312, the OR circuit 313, the AND circuits 314, 315, the latch 1, and the latch 2 of the scan FF 201 have the same configurations as the AND circuits 311, 312, the OR circuit 313, the AND circuits 314, 315, the latch 1, and the latch 2 of the boundary scan circuit 310.

One terminal of the AND circuit 311 is connected to the input terminal 230A (see FIG. 1) of the scan chain 230, and thus becomes the scan in terminal SI of the AND circuit 311. To the other terminal of the AND circuit 311, an A clock ACK is input from the test control circuit 250.

One terminal of the AND circuit 312 is connected to the input circuit 142, and to the other terminal of the AND circuit 312, a test clock TCK is input from the test control circuit 250.

Furthermore, the data output terminal q of the latch 2 is connected to the input terminal of the combination circuit 101 and the scan in terminal SI of the scan FF 202.

Incidentally, the input output relationship of the OR circuit 313, the AND circuits 314, 315, and the latch 1 is the same as that of the OR circuit 313, the AND circuits 314, 315, and the latch 1 of the boundary scan circuit 310 illustrated in FIG. 2.

The connection relationship of the data input terminal D, the data output terminal Q, the scan in terminal SI, and the scan out terminal SO of the scan FFs 202 through 228 is as illustrated in FIG. 1.

In the scan test, the test control circuit 250 sets test data for the scan test input from an external test device in each of the scan FFs 201 through 224 via the scan in terminals SI and the scan out terminals SO of the scan chain 230 and the scan FFs 201 through 228.

Next, the test control circuit 250 inputs the test data set in each of the scan FFs 201 through 224 in the combination circuits 101 through 106 from the data output terminal Q. Accordingly, the combination circuits 101 through 106 output result data according to the logic set inside. The result data output from the combination circuits 101 through 106 is input to the data input terminals D of the scan FFs 205 through 228.

Then, the test control circuit 250 operates the scan FFs 201 through 228 and transfers the result data in the data input terminals D of the scan FFs 205 through 228 to the data output terminal Q, and extracts the result data output from the combination circuits 101 through 106 via the scan chain 230.

The result data of the combination circuits 101 through 106 extracted by the test control circuit 250 is compared with the expectation value data with respect to the test data in an external test device such as an LSI tester, so that a determination is made as to whether the combination circuits 101 through 106 are normally operating.

That is to say, 1 when the result data and the expectation value data match, the LSI 1 is determined as non-defective, 1 and when the result data and the expectation value data do not match, the LSI 1 is determined as defective.

In the LSI 1 according to the comparative example described above, the combination circuits 101 through 106 perform scan shift between FFs by the scan FFs 201 through 228, and therefore an operation check by a scan test is possible.

However, 1 the combination circuit 110 is not connected to a scan chain, and is not able to perform scan shift between FFs, and therefore there is a problem that the operation check is not possible for the combination circuit 110.

As described above, in the LSI 1 according to the comparative example, 1 there is the problem that operation check is not possible for the combination circuit 110 that is not connected to a scan chain.

Thus, 1 in the following embodiments, it is an objective to provide an integrated circuit and an information processing device in which the above problems are solved. In the following, a description is given of an integrated circuit and an information processing device according to embodiments.

### First embodiment

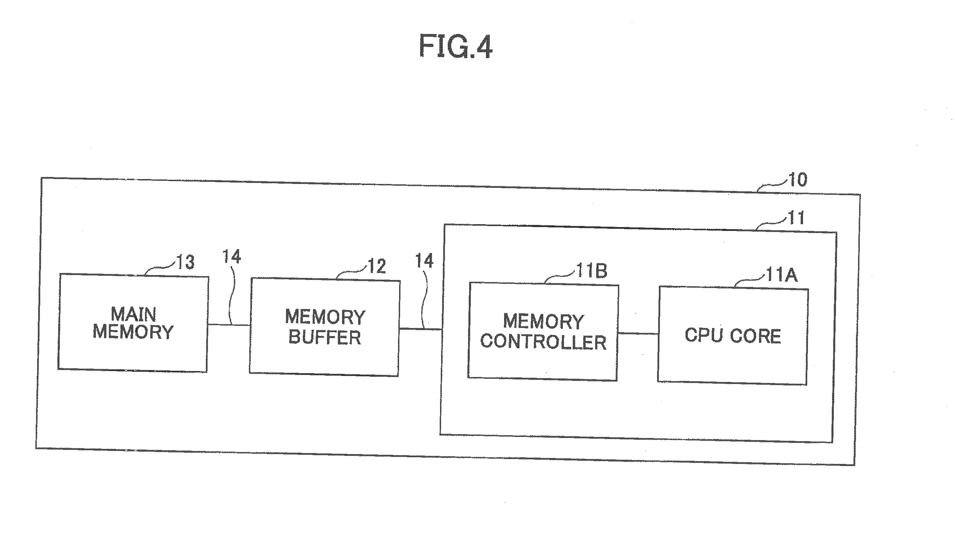

FIG. 4 illustrates an information processing device including an integrated circuit according to a first embodiment.

A server 10 which is an information processing device including an integrated circuit according to the first embodiment includes a CPU (Central Processing Unit) 11, a memory buffer 12, and a main memory 13. The CPU 11, the memory buffer 12, and the main memory 13 are connected by, for example, a dedicated system bus 14.

The CPU 11 includes a CPU core 11A and a memory controller 11B.

The memory buffer 12 transfers data between the memory controller 11B and the main memory 13.

The main memory 13 is constituted by a memory module such as a DIMM (Dual Inline Memory Module).

The integrated circuit according to the first embodiment may be used as, for example, the memory buffer 12.

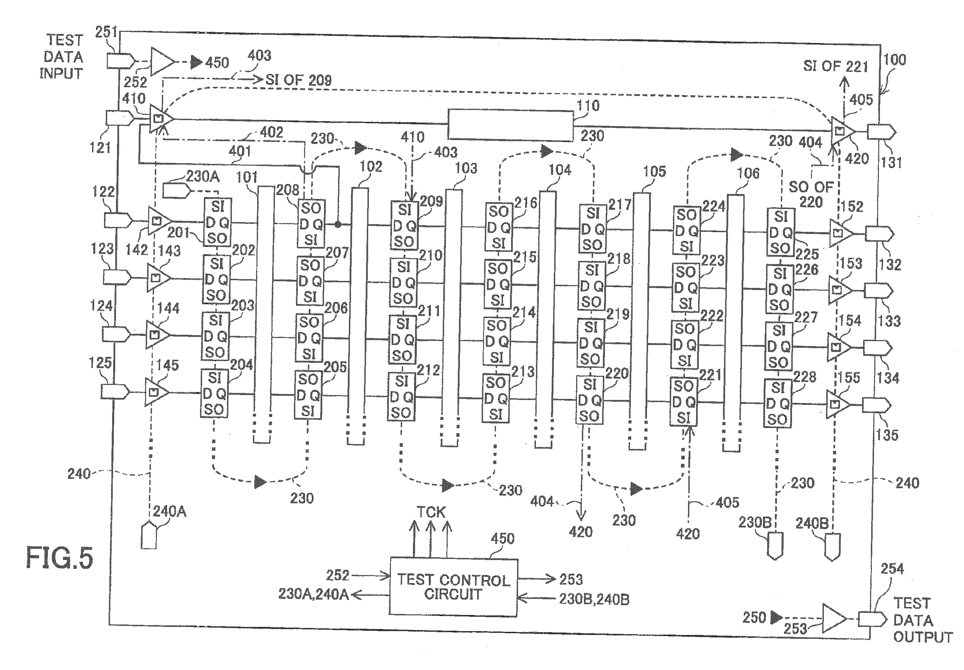

Next, with reference to FIG. 5, a description is given of a LSI 100 that is an integrated circuit according to the first embodiment.

In the following description of the LSI 100 according to the first embodiment, elements that are the same as or equivalent to those of the LSI 1 according to the comparative example in FIG. 1 are denoted by the same reference numerals and are not further described.

FIG. 5 is a block diagram of the LSI 100 according to the first embodiment.

The LSI 100 includes combination circuits 101 through 106, a combination circuit 110, input terminals 121 through 125, output terminals 131 through 135, an input circuit 410, input circuits 142 through 145, an output circuit 420, and output circuits 152 through 155. Furthermore, the LSI 100 includes scan FFs 201 through 228, a scan chain 230, a boundary scan chain 240, a test control circuit 450, a test data input terminal 251, an input circuit 252, an output circuit 253, and a test data output terminal 254.

The LSI 100 further includes a data transfer circuit 401 and insertion circuits 402, 403, 404, and 405.

The combination circuits 101 through 106 are examples of first combination circuits. The combination circuits 101 through 106 and the scan FFs 201 through 228 are examples of first signal processing circuits in which plural first combination circuits and plural scan FFs are connected in an order of a scan FF, a first combination circuit, and a scan FF.

The input circuit 410, the combination circuit 110, and the output circuit 420 are examples of second signal processing circuits.

The input circuit 410 and the output circuit 420 are provided instead of the input circuit 141 and the output circuit 151 of FIG. 1, and have internal circuit configurations that are different from those of the input circuit 141 and the output circuit 151 of FIG. 1.

The test control circuit 450 implements different control from that of the test control circuit 250 in FIG. 1.

The data transfer circuit 401 connects the data output terminal Q of the scan FF 208 and the data input terminal of the input circuit 410, and is provided for transferring data for an operation check to the combination circuit 110 when performing an operation check test of the combination circuit 110.

The insertion circuits 402, 403 are provided for inserting the input circuit 410 in the scan chain 230.

The insertion circuits 404, 405 are provided for inserting the output circuit 420 in the scan chain 230.

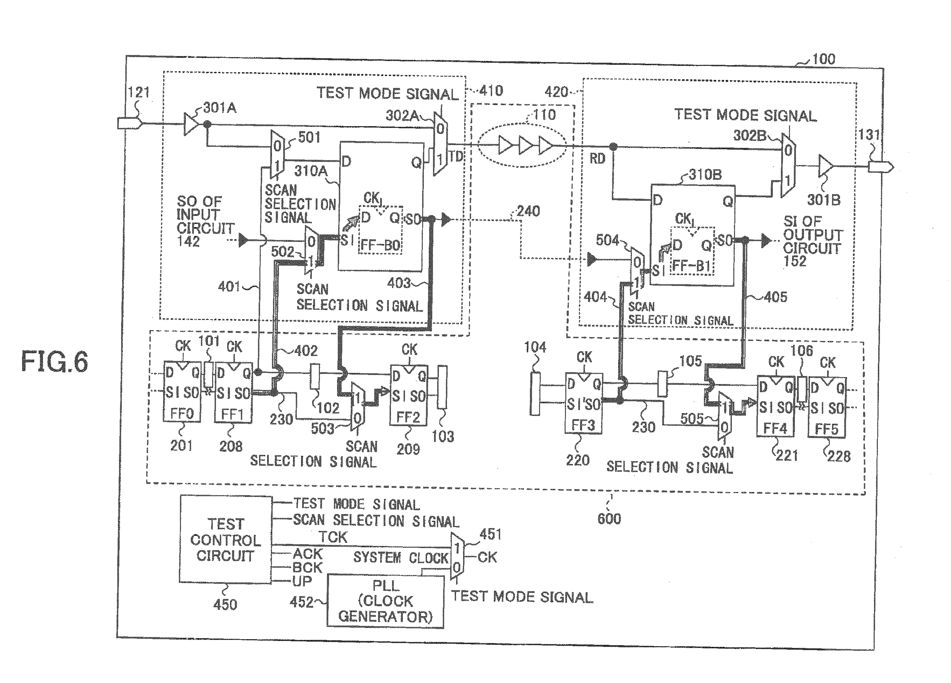

The LSI 100 according to the first embodiment uses the data transfer circuit 401 and the insertion circuits 402, 403, 404, and 405 to perform an operation check of the combination circuit 110. Details are described below with reference to FIG. 6.

FIG. 6 is a partial enlargement of the LSI 100 according to the first embodiment.

The part of the LSI 100 illustrated in FIG. 6 corresponds to the input circuit 410, the combination circuit 110, the output circuit 420, the data transfer circuit 401, the insertion circuits 402, 403, 404, and 405, and surrounding circuits illustrated in FIG. 5.

As illustrated in FIG. 6, the input circuit 410 includes an input buffer 301A, a selector 302A, a boundary scan circuit 310A, and also selectors 501, 502. Among these elements, the input buffer 301A, the selector 302A, and the boundary scan circuit 310A have the same configurations as the input buffer 301, the selector 302, and the boundary scan circuit 310 of the input circuit 141 illustrated in FIG. 2. The boundary scan circuit 310A is an example of a first scan FF.

The selector 302A is an example of a test data selection circuit that selects a signal from either one of the input buffer 301A or the boundary scan circuit 310A based on a test mode signal input from the test control circuit 450, and outputs the selected signal. To the output terminal of the selector 302A, the combination circuit 110 is connected.

The selector 302B selects a signal from either one of the combination circuit 110 or a boundary scan circuit 310B based on a test mode signal input from the test control circuit 450, and outputs the selected signal. To the output terminal of a selector 302B, the output terminal 131 is connected via an output buffer 301B.

In the first embodiment, a test mode signal of "0" indicates that a regular system operation is performed, and the data input from the input terminal 121 to the selector via the input buffer 301 is input to the combination circuit 110. The output data from the combination circuit 110 is input to the output buffer 301B via the selector 302B.

A test mode signal of "1" indicates that a boundary scan test or a scan test is performed. When the test mode signal is "1", the selector 302A selects data input from the boundary scan circuit 310A, and inputs the data in the combination circuit 110.

To one input terminal of the selector 501, the input buffer 301A is connected, and to the other input terminal of the selector 501, the data output terminal Q of the scan FF 208 is connected via the transfer circuit 401. The selector 501 functions as an example of a first selecting circuit for selectively switching the input source of data by a scan selection signal input from the test control circuit 450.

The selector 501 acting as a first selection circuit switches the input source of data between the scan FF 208 on the input side of the combination circuit 102 that is a first combination circuit, and the input terminal 121 that is an example of an input terminal of a second signal processing circuit.

Here, the scan selection signal is a signal for selectively switching whether to perform a scan test for performing an operation check of the combination circuit 110.

A value of a scan selection signal of "0" indicates that an operation check of the combination circuit 110 is not performed, and the selector 501 selects the input buffer 301A as the input source of data.

A value of a scan selection signal of "1" indicates that a scan test for performing an operation check of the combination circuit 110 is performed, and the selector 501 selects, as the input source of data, a data output terminal Q of the scan FF 208 connected via the data transfer circuit 401.

To one input terminal of the selector 502, a scan output terminal SO of the scan FF 208 is connected via the insertion circuit 402, and to the other input terminal of the selector 502, a scan out terminal SO of the input circuit 142 is connected. The selector 502 selectively switches the input source of data by a scan selection signal input from the test control circuit 450.

When the value of a scan selection signal is "0", the selector 502 selects the scan out terminal SO of the input circuit 142 as the input source of data. This corresponds to a case of performing a boundary scan test.

When the value of a scan selection signal is "1", the selector 502 selects the scan out terminal SO of the scan FF 208 connected via the insertion circuit 402, as the input source of data.

On the input side of a scan in terminal SI of the scan FF 209, a selector 503 is provided.

To one input terminal of the selector 503, a scan output terminal SO of the scan FF 208 is connected via the scan chain 230, and to the other input terminal of the selector 503, a scan out terminal SO of the boundary scan circuit 310A is connected via the insertion circuit 403.

The selector 503 selectively switches the input source of data by a scan selection signal input from the test control circuit 450.

A value of a scan selection signal of "0" indicates that an operation check of the combination circuit 110 is not performed, and the selector 503 selects a scan out terminal SO of the scan FF 208 as the input source of data. This connection state corresponds to a case where a scan test of the combination circuit 102 is performed.

A value of a scan selection signal of "1" indicates that a scan test for performing an operation check of the combination circuit 110 is performed, and the selector 503 selects, as the input source of data, a scan out terminal SO of the boundary scan circuit 310A connected via the insertion circuit 403.

The insertion circuits 402, 403 are examples of first insertion circuits for inserting FF-B0 in the boundary scan circuit 310A into the scan chain. The FF-B0 is described below.

The output circuit 420 includes the output buffer 301B, the selector 302B, the boundary scan circuit 310B, and also a selector 504. Among these elements, the selector 302B and the boundary scan circuit 310B have the same configurations as the selector 302 and the boundary scan circuit 310 of the input circuit 141 illustrated in FIG. 2. The boundary scan circuit 310B is an example of a second scan FF.

Furthermore, the output buffer 301B is provided for transmitting output data before outputting data to a circuit or a device connected to the outside of the output terminal 131.

To one input terminal of the selector 504, a scan output terminal SO of the boundary scan circuit 310A is connected via the boundary scan chain 240, and to the other input terminal of the selector 504, a scan out terminal SO of the scan FF 220 is connected via the insertion circuit 404. The selector 504 selectively switches the input source of data by a scan selection signal input from the test control circuit 450.

A value of a scan selection signal of "0" indicates that an operation check of the combination circuit 110 is not performed, and the selector 504 selects a scan out terminal SO of the boundary scan circuit 310A as the input source of data. This corresponds to a case where a boundary scan test is performed.

A value of a scan selection signal of "1" indicates that a scan test for performing an operation check of the combination circuit 110 is performed, and the selector 504 selects, as the input source of data, a scan out terminal SO of the scan FF 220 connected via the insertion circuit 404.

On the input side of a scan in terminal SI of the scan FF 221, a selector 505 is provided.

To one input terminal of the selector 505, a scan output terminal SO of the scan FF 220 is connected via the scan chain 230, and to the other input terminal of the selector 505, a scan out terminal SO of the boundary scan circuit 310B is connected via the insertion circuit 405.

The selector 505 is an example of a second selection circuit that selectively switches the input source of data by a scan selection signal input from the test control circuit 450.

As the selector 505 functioning as the second selection circuit switches the input source of data, the data input source of the scan FF 2221 on the output side of the combination circuit 105 that is a first combination circuit is switched between the combination circuit 105 that is a first combination circuit and the combination circuit 110 that is a second combination circuit.

A value of a scan selection signal of "0" indicates that an operation check of the combination circuit 110 is not performed, and the selector 505 selects the scan out terminal SO of the scan FF 220 connected via the scan chain 230, as the input source of data. This connection state corresponds to a case where a scan test of the combination circuit 105 is performed.

A value of a scan selection signal of "1" indicates that a scan test for performing an operation check of the combination circuit 110 is performed, and the selector 505 selects, as the input source of data, a scan out terminal SO of the boundary scan circuit 310B connected via the insertion circuit 405.

The insertion circuits 404, 405 are examples of second insertion circuits for inserting FF-B1 in the boundary scan circuit 310B into the scan chain 230. The FF-B1 is described below.

To the terminal of the test control circuit 450 for outputting a test clock, a selector 451 is connected.

To one input terminal of the selector 451, a terminal of the test control circuit 450 for outputting a test clock TCK is connected, and to the other input terminal of the selector 451, a PLL (phase-locked loop circuit) 452 for outputting a system clock CK is connected.

The selector 451 selectively switches the clock to be output to either the test clock TCK or the system clock CK, according to a test mode signal output from the test control circuit 450. The clock input terminal of the scan FF 201, 208, 209, 220, 221, 228, the flip flops FF-B0, FF-B1 is expressed as CK. To each clock input terminal CK, the output terminal of the selector 451 is connected, and the test clock TCK or the system clock CK selected by the selector 451 is input.

The test mode signal is a signal for turning on or off the test mode for performing a scan test or a boundary scan test.

When performing the LSI test, the value of the test mode signal is set to "1", and the selector 451 outputs the test clock TCK output from the test control circuit 450.

In a regular system operation, the value of the test mode signal is set to "0", and the selector 451 outputs a system clock output from the PLL 452. This system clock is a clock that is used when the LSI 100 performs a regular operation.

In the above-described LSI 100 according to the first embodiment, when performing the operation check test of the combination circuit 110, the test control circuit 450 sets the test mode signal to "1", and sets the scan selection signal to "1".

Accordingly, as indicated by thick arrows in FIG. 6, the FF-B0 in the boundary scan circuit 310A may be incorporated in part of the scan chain 230 via the insertion circuit 402, the selector 502, the insertion circuit 403, and the selector 503. Furthermore, the FF-B1 in the boundary scan circuit 310B may be incorporated in part of the scan chain 230 via the insertion circuit 404, the selector 504, the insertion circuit 405, and the selector 505.

When performing the operation check test of the combination circuit 110, the data set in the data output terminal Q of the FF-B0 in the boundary scan circuit 310A is input as test data in the combination circuit 110 via the selector 302A. The result data of the combination circuit 110 is input in the data input terminal D of the FF-B1 in the boundary scan circuit 310B, and is extracted outside the LSI 100 via the insertion circuit 405 and the scan chain 230.

When a timing chart is used for a description below, the scan FF 201, 208, 209, 220, 221, and 228 are simply referred to as FF0, FF1, FF2, FF3, FF4, and FF5, respectively.

In the LSI 100 according to the first embodiment described above, the part including the combination circuits 101 through 106 and the combination circuit 110 is a test target 600 of a LSI test.

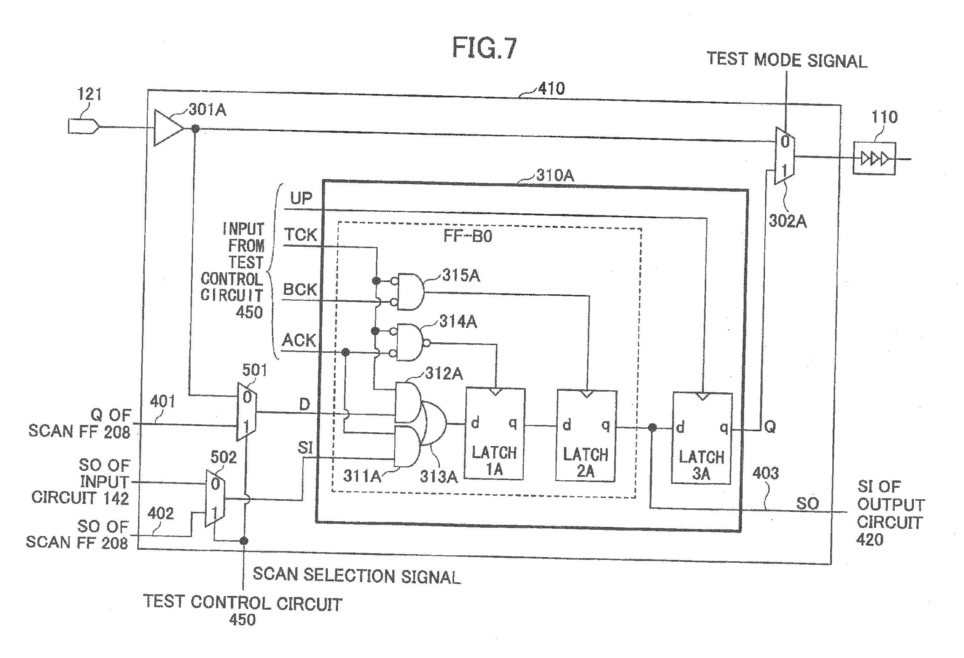

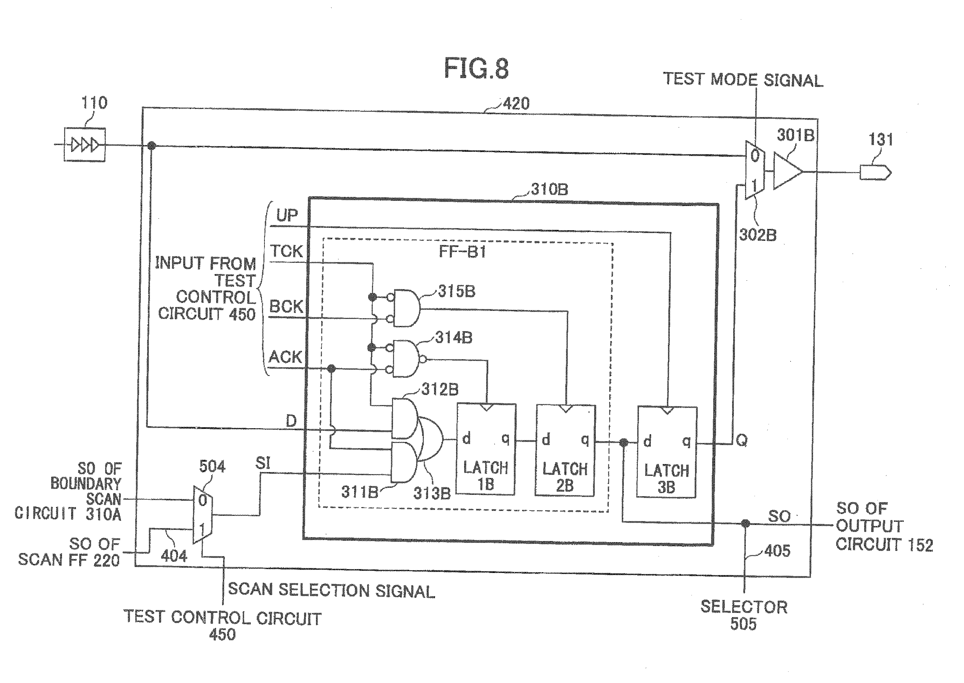

Next, with reference to FIGS. 7 and 8, a description is given of the internal configurations of the input circuit 410 and the output circuit 420.

FIG. 7 illustrates a circuit of the input circuit 410 of the LSI 100.

FIG. 7 illustrates in detail the inside of the boundary scan circuit 310A in the input circuit 410 illustrated in FIG. 6.

The boundary scan circuit 310A includes AND circuits 311A, 312A, an OR circuit 313A, AND circuits 314A, 315A, a latch 1A, a latch 2A, and a latch 3A.

The AND circuits 311A, 312A, the OR circuit 313A, the AND circuits 314A, 315A, the latch 1A, the latch 2A, and the latch 3A respectively have the same configurations as the AND circuits 311, 312, the OR circuit 313, the AND circuits 314, 315, the latch 1, the latch 2, and the latch 3 of the input circuit 141 illustrated in FIG. 2.

The connection relationship of the AND circuits 311A, 312A, the OR circuit 313A, the AND circuits 314A, 315A, the latch 1A, the latch 2A, and the latch 3A has the same configuration as the connection relationship of the AND circuits 311, 312, the OR circuit 313, the AND circuits 314, 315, the latch 1, the latch 2, and the latch 3 of the input circuit 141 illustrated in FIG. 2. Accordingly, the connection relationship of the AND circuits 311A, 312A, the OR circuit 313A, the AND circuits 314A, 315A, the latch 1A, the latch 2A, and the latch 3A is not further described.

In the following, a flip flop (FF) including the AND circuits 311A, 312A, the OR circuit 313A, the AND circuits 314A, 315A, the latch 1A, and the latch 2A is referred to as FF-B0. The circuit configuration of the FF-B0 is the same as the circuit configuration of the scan FFs 201 through 228 (see FIG. 3).

FIG. 8 illustrates a circuit of the output circuit 420 of the LSI 100.

FIG. 8 illustrates in detail the inside of the boundary scan circuit 310B in the output circuit 420 illustrated in FIG. 6.

The boundary scan circuit 310B includes AND circuits 311B, 312B, an OR circuit 313B, AND circuits 314B, 315B, a latch 1B, a latch 2B, and a latch 3B.

The AND circuits 311B, 312B, the OR circuit 313B, the AND circuits 314B, 315B, the latch 1B, the latch 2B, and the latch 3B respectively have the same configurations as the AND circuits 311, 312, the OR circuit 313, the AND circuits 314, 315, the latch 1, the latch 2, and the latch 3 of the input circuit 141 illustrated in FIG. 2.

The connection relationship of the AND circuits 311B, 312B, the OR circuit 313B, the AND circuits 314B, 315B, the latch 1B, the latch 2B, and the latch 3B has the same configuration as the connection relationship of the AND circuits 311, 312, the OR circuit 313, the AND circuits 314, 315, the latch 1, the latch 2, and the latch 3 of the input circuit 141 illustrated in FIG. 2. Accordingly, the connection relationship of the AND circuits 311B, 312B, the OR circuit 313B, the AND circuits 314B, 315B, the latch 1B, the latch 2B, and the latch 3B is not further described.

In the following, a flip flop (FF) including the AND circuits 311B, 312B, the OR circuit 313B, the AND circuits 314B, 315B, the latch 1B, and the latch 2B is referred to as FF-B1. The circuit configuration of the FF-B1 is the same as the circuit configuration of the FF-B0 (see FIG. 7) and the scan FFs 201 through 228 (see FIG. 3).

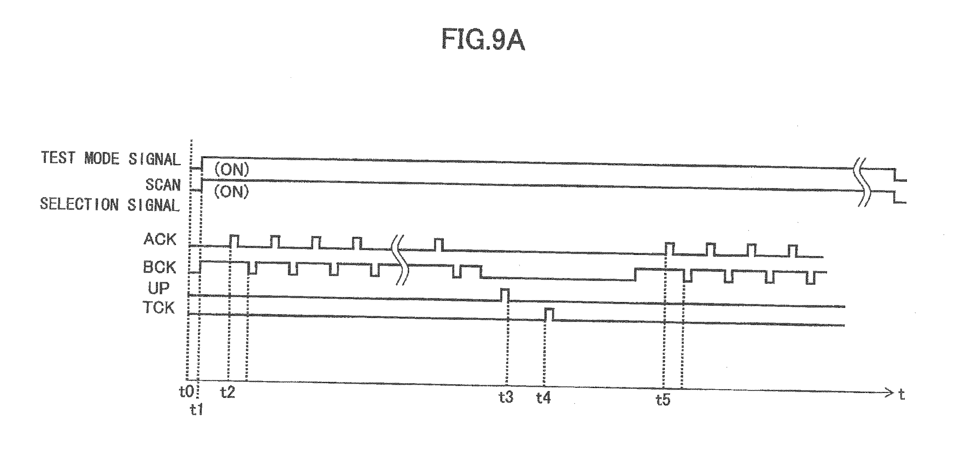

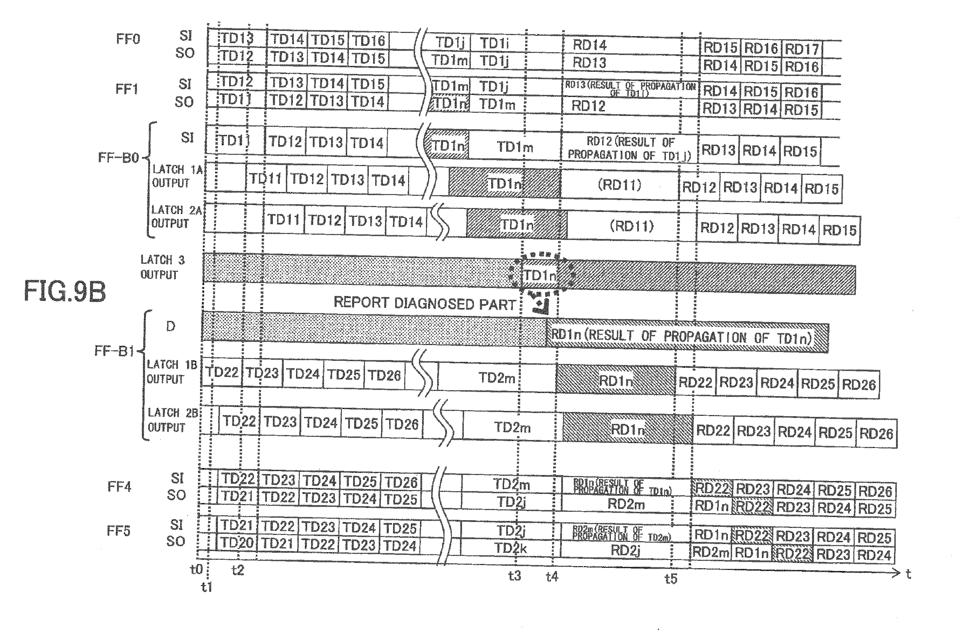

Next, with reference to the timing chart of FIGS. 9A and 9B, a description is given of an operation check test of the combination circuit 110 in the LSI 100 according to the first embodiment.

FIGS. 9A and 9B indicate a timing chart indicating the timings of various signals and various clocks when performing an operation check test of the combination circuit 110 of the LSI 100 according to the first embodiment. Although divided into FIG. 9A and FIG. 9B, FIG. 9A and FIG. 9B indicate a single timing chart.

In the following, an A clock ACK, a B clock BCK, a test clock TCK, and an update signal UP are simply referred to as ACK, BCK, TCK, and UP, respectively.

Furthermore, the scan in terminal SI and the scan out terminal SO are referred to as SI and SO, respectively.

Here, ACK, BCK, and TCK are driven at timings indicated in FIG. 9A.

In FF-B0 illustrated in FIG. 7, the clock signal input to the latch 1A is L level and the clock signal input to the latch 2A is L level, when CK is L level, ACK is L level, and BCK is H level. Furthermore, the clock signal input to the latch 1A is H level and the clock signal input to the latch 2A is L level, when TCK is L level, ACK is H level, and BCK is H level.

That is to say, in the timing chart in FIG. 9A, in a state where TCK is L level and BCK is H level, when ACK rises, the value of the data input terminal d of the latch 1A may be applied to the data output terminal q of the latch 1A.

Furthermore, in FF-B0, the clock signal input to the latch 1A is L level and the clock signal input to the latch 2A is L level, when TCK is L level, ACK is L level, and BCK is H level. Furthermore, the clock signal input to the latch 1A is L level and the clock signal input to the latch 2A is H level, when TCK is L level, ACK is L level, and BCK is L level.

That is to say, in the timing chart in FIG. 9A, in a state where TCK is L level and ACK is L level, when BCK falls, the value of the data input terminal d of the latch 2A may be applied to the data output terminal q of the latch 2A.

Furthermore, in FF-B0, the clock signal input to the latch 1A is L level and the clock signal input to the latch 2A is L level, when TCK is L level, ACK is L level, and BCK is L level. Furthermore, the clock signal input to the latch 1A is H level and the clock signal input to the latch 2A is L level, when TCK is H level, ACK is L level, and BCK is L level.

That is to say, in the timing chart in FIG. 9A, in a state where ACK is L level and BCK is L level, when TCK rises, the value of the data input terminal d of the latch 1A may be applied to the data output terminal q of the latch 1A.

Furthermore, in FF-B0, the clock signal input to the latch 1A is L level and the clock signal input to the latch 2A is L level, when TCK is H level, ACK is L level, and BCK is L level. Furthermore, the clock signal input to the latch 1A is L level and the clock signal input to the latch 2A is H level, when TCK is L level, ACK is L level, and BCK is L level.

That is to say, in the timing chart in FIG. 9A, in a state where ACK is L level and BCK is L level, when TCK falls, the value of the data input terminal d of the latch 2A may be applied to the data output terminal q of the latch 2A.

It is assumed that the latch 3A applies the value of the data input terminal d to the data output terminal q when UP falls from an H level to an L level.

The above logic is also the same for FF-B1 having the same circuit configuration and input signals as the FF-B0.

Furthermore, as described above, the scan FFs 201 through 228 have the same circuit configuration and input signals as the FF-B0 and the FF-B1, and the value of the scan out terminal SO of the scan FFs 201 through 228 is the value of the data output terminal q of the latch 2 included in the scan FFs 201 through 228. Accordingly, the value of the scan out terminal SO of the scan FFs 201 through 228 is updated when the BCK falls in a state where TCK is L level and ACK is L level.

Furthermore, as described above, in the following description of the timing chart, the scan FF 201, 208, 209, 220, 221, and 228 are expressed as FF0, FF1, FF2, FF3, FF4, and FF5, respectively. Therefore, the value of the scan out terminal SO of FF0, FF1, FF2, FF3, FF4, and FF5 is updated when the BCK falls in a state where TCK is L level and ACK is L level.

Furthermore, in the following, data to be input to the combination circuit 110 is referred to as test data, which is abbreviated as TD. Furthermore, TD is processed at the combination circuit 110, and becomes result data. In the following, result data is abbreviated as RD.

In the following, a description is given of an operation check test of the combination circuit 110 using the above logic.

At time t0, both the test mode signal and scan selection signal are L level, and ACK, BCK, UP, and TCK are all L level.

Furthermore, it is assumed that there is TD 13 at SI of FF0 and that there is TD 12 at SO of FF0. It is assumed that there is TD 12 at SI of FF1 and that there is TD 11 at SO of FF1. It is assumed that output of the latch 1B of FF-B1 is TD22.

At time t1, both the test mode signal and scan selection signal rise to H level, and BCK rises to H level.

At time t2, ACK rises for the first time and becomes H level. At this time, the latch 1A of FF-B0 applies the value of the data input terminal d (SO) to the data output terminal q, and thus becomes TD11. Furthermore, it is assumed that the latch 1A of FF-B1 becomes TD23.

Next, BCK falls for the first time, and becomes L level. At this time, the SO of FF0 takes in the value (TD13) of the SI before the BCK falls, and becomes TD13. Furthermore, to the SI of FF0, TD14 which is the next test data is input. Similarly, SO of FF1 takes in the value (TD12) of the SI before the BCK falls, and becomes TD12. Furthermore, to the SI of FF1, the value output from the SO of FF0 is input, and thus becomes TD13.

The latch 2A of FF-B0 takes in the output (TD11) of the latch 1A before the BCK falls, and becomes TD11.

The latch 2B of FF-B1 takes in the output (TD23) of the latch 1B before the BCK falls, and becomes TD23.

The SO of FF4 takes in the value (TD22) of the SI before the BCK falls, and becomes TD22. To the SI of FF4, TD23 which is the next test data is input. Similarly, SO of FF5 takes in the value (TD21) of the SI before the BCK falls, and becomes TD21. Furthermore, to the SI of FF5, the value output from the SO of FF4 is input, and thus becomes TD22.

Thereafter, until a time t3, when the ACK rises and when the BCK rises, the same operation is repeatedly executed, and the values of FF0, FF1, FF-B0, FF-B1, FF4, and FF5 are sequentially replaced.

When UP rises immediately before the time t3, and UP falls at time t3, the latch 3A of the boundary scan circuit 310A takes the output (TD1n) of the latch 2A, and thus becomes TD1n.

Accordingly, the output value (TD1n) of the latch 3A is input to the combination circuit 110 via the selector 302A (see FIG. 7).

The combination circuit 110 performs a calculation based on TD1n, and outputs result data RD1n. The RD1n output from the combination circuit 110 is input to the data input terminal D of the boundary scan circuit 310B (see FIG. 8).

Subsequently, when TCK rises at time T4, the latch 1B takes in RD1n.

Next, when TCK falls, the latch 2B takes in the output of the latch 1B.

Furthermore, subsequently, from time t5 and onward, the ACK rises and the BCK falls again repeatedly, so that the result data RD1n processed at the combination circuit 110 is sequentially transferred to the FF4 and FF5.

By repeatedly executing the above process, the result data (RD1n) processed at the combination circuit 110 is extracted.

The extracted result data is compared with the test data that is the expectation value at the external test device, and the operation check of the combination circuit 110 is performed.

As described above, with the LSI 100 according to the first embodiment, the input circuit 410 and the output circuit 420 including the boundary scan circuits 310A and 310B are used to insert the combination circuit 110 to part of a data transfer path formed by the scan chain 230. Therefore, the operation check of the combination circuit 110 may be performed.

The operation of inserting the combination circuit 110 to part of a data transfer path formed by the scan chain 230 is realized as the LSI 100 includes the data transfer circuit 401, the insertion circuits 402 through 405, and the selectors 501, 502, 503, and 504.

Thus, by adding a minimum number of elements (the data transfer circuit 401, the insertion circuits 402 through 405, and the selectors 501, 502, 503, and 504) to the boundary scan circuit 310 (see FIG. 2) of the LSI 1 according to the comparative example illustrated in FIG. 1, it is possible to realize the operation check of the combination circuit 110 that is not possible by the comparative example.

In the above-described embodiment, the input terminal of the combination circuit 110 is connected to the scan FF 208 and data for a scan test is input to the combination circuit 110, and the output terminal of the combination circuit 110 is connected to the scan FF 221 and output data of the combination circuit 110 is extracted.

However, the input terminal and the output terminal of the combination circuit 110 may be connected to any of the scan FFs, and by forming the data transfer path so that the combination circuit 110 is inserted in part of the scan chain 230, the operation check of the combination circuit 110 may be performed in the same manner as described above.

### Second embodiment

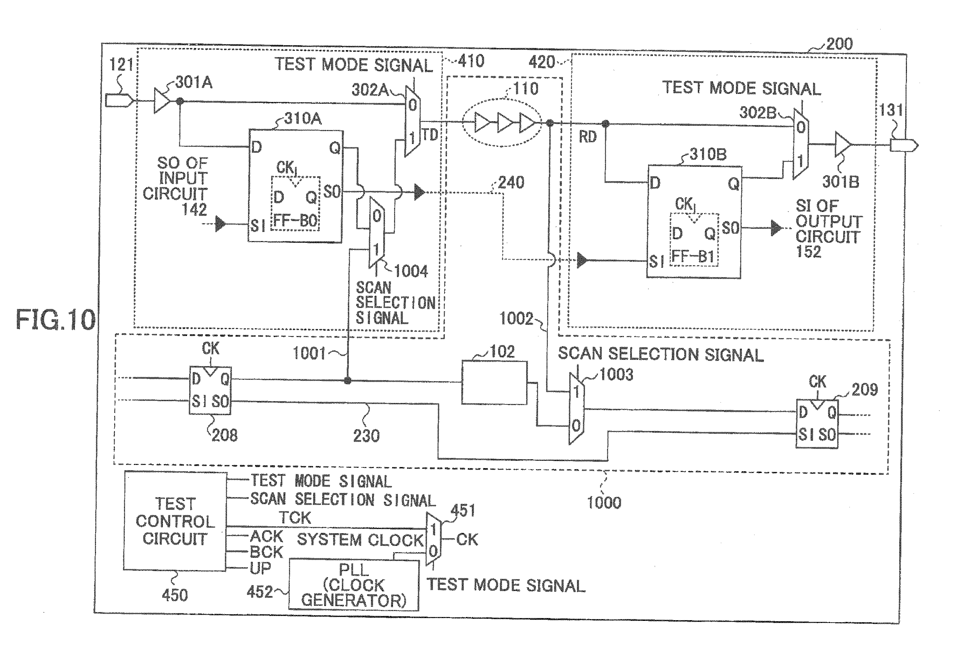

FIG. 10 is a partial enlargement of a LSI 200 according to a second embodiment.

The part of the LSI 200 illustrated in FIG. 10 corresponds to the part of the LSI 100 according to the first embodiment illustrated in FIG. 6. However, FIG. 10 only illustrates the section of the scan FF 208 and the scan FF 209 provided on the input side and the output side of the combination circuit 102 acting as a first combination circuit.

The LSI 200 according to the second embodiment is different from the LSI 100 according to the first embodiment in that the operation check of the combination circuit 110 acting as the second combination circuit is performed without using the boundary scan circuits 310A and 310B.

In the following, elements that are the same as or equivalent to those of the LSI 100 according to the first embodiment are denoted by the same reference numerals and are not further described.

The LSI 200 is different from the LSI 100 according to the first embodiment in that a transfer circuit 1001, a transfer circuit 1002, a selector 1003, and a selector 1004 are included.

The transfer circuit 1001 connects the data output terminal Q of the scan FF 208 with one input terminal of the selector 1004. To one input terminal of the selector 1004, the transfer circuit 1001 is connected, and to the other input terminal of the selector 1004, the data output terminal Q of the boundary scan circuit 310A is connected. The output terminal of the selector 1004 is connected to one input terminal of the selector 302A.

The transfer circuit 1001 and the selector 1004 function as a first selection circuit that switches the output destination of the data of the scan FF 208 between the combination circuit 102 and the combination circuit 110.

The transfer circuit 1002 connects the output terminal of the combination circuit 110 with one input terminal of the selector 1003.

To the other input terminal of the selector 1003, the output terminal of the combination circuit 102 is connected.

The transfer circuit 1002 and the selector 1003 function as a second selection circuit that switches the input source of the data of the scan FF 209 between the combination circuit 102 and the combination circuit 110.

To the selector 1003, scan selection signals are input from the test control circuit 450. When the value of the scan selection signal becomes 1, the selector 1003 connects the transfer circuit 1002 with the data input terminal D of the scan FF 209. This is a case of performing the operation check test of the combination circuit 110 in the LSI test.

Meanwhile, when the value of the scan selection signal input from the test control circuit 450 becomes 0, the selector 1003 connects the combination circuit 102 and the data input terminal D of the scan FF 209. This is a case of performing the operation check test of the combination circuit 102 in the LSI test.

As described above, according to the second embodiment, without using the boundary scan circuits 310A and 310B, by inserting the combination circuit 110 in part of the data transfer path formed by the scan chain 230, operation check of the combination circuit 110 may be performed.

The operation of inserting the combination circuit 110 in part of the data transfer path formed by the scan chain 230 is realized as the LSI 200 includes the transfer circuit 1001, the transfer circuit 1002, and the selector 1003.

Thus, by adding a minimum number of elements (the transfer circuit 1001, the transfer circuit 1002, and the selector 1003) to the boundary scan circuit 310 (see FIG. 2) of the LSI 1 according to the comparative example indicated in FIG. 1, it is possible to realize the operation check of the combination circuit 110 that is not possible by the comparative example.

The integrated circuit according to the first and second illustrative embodiments of present invention described above is not limited to the specific embodiments described herein, and variations and modifications may be made without departing from the scope of the present invention.

### DESCRIPTION OF THE REFERENCE NUMBERS

10 server
11 CPU
11A CPU core
11B memory controller
12 memory buffer
13 main memory
14 system bus
100 LSI
101-106, 110 combination circuit
121-125 input terminal
131~135 output terminal
410, 142-145 input circuit
420, 152-155 output circuit
201-228 scan FF
230 scan chain
240 boundary scan chain
250, 450 test control circuit
251 test data input terminal
252 input circuit
253 output circuit
254 test data output terminal
401 data transfer circuit
402, 403, 404, 405 insertion circuit
501, 502, 503, 504, 505 selector
600 test target
301A input buffer
302A selector
310A boundary scan circuit
311A, 312A AND circuit
313A OR circuit
314A, 315A AND circuit
1A, 2A, 3A latch
301B output buffer
302B selector
310B boundary scan circuit
311B, 312B AND circuit
313B OR circuit
314B, 315B AND circuit
1B, 2B, 3B latch
1001 transfer circuit
1002 transfer circuit
1003 selector

## Claims

1. An integrated circuit comprising:
a first signal processing circuit in which a plurality of first combination circuits and a plurality of scan FFs (Flip Flop) are connected in an order of a scan FF, a first combination circuit, and a scan FF;
a second signal processing circuit including a second combination circuit different from the first combination circuit;
a first selection circuit configured to select data from a scan FF on an input side of one of the plurality of first combination circuits or data from an input terminal of the second signal processing circuit, and to output the selected data to the second combination circuit; and
a second selection circuit configured to select data from another one of the plurality of first combination circuits different from the one of the plurality of first combination circuits or data from the second combination circuit, and to output the selected data to the scan FF on an output side of the another one of the plurality of first combination circuits.

2. The integrated circuit according to claim 1, wherein
the second signal processing circuit includes
a first scan FF for boundary scan connected to an input side of the second combination circuit and
a second scan FF for boundary scan connected to an output side of the second combination circuit,
when the first selection circuit selects the scan FF on the input side of the one of the plurality of first combination circuits, the first selection circuit outputs the selected data to the second combination circuit via the first scan FF, and
when the second selection circuit selects the second combination circuit, the second selection circuit outputs the selected data to the scan FF on the output side of the another one of the plurality of first combination circuits via the second scan FF.

3. The integrated circuit according to claim 2, further comprising:
a test data selection circuit provided between the first scan FF and the second combination circuit, the test data selection circuit being configured to select test data for boundary scan input to the input terminal of the second signal processing circuit and test data for a scan test output from a data output terminal of the first scan FF, and to output the selected test data to the second combination circuit.

4. The integrated circuit according to claim 2, further comprising:
a scan chain configured to connect scan terminals of the plurality of scan FFs;
a first insertion circuit configured to insert the first scan FF in the scan chain; and
a second insertion circuit configured to insert the second scan FF in the scan chain.

5. The integrated circuit according to claim 4, wherein
the first insertion circuit includes
a first selector provided on an input side of a scan in terminal of the first scan FF and
a second selector provided on an output side of a scan out terminal of the first scan FF, and is configured to insert the first scan FF in the scan chain by switching between the first selector and the second selector, and
the second insertion circuit includes
a third selector provided on an input side of a scan in terminal of the second scan FF and a fourth selector provided on an output side of a scan out terminal of the second scan FF, and is configured to insert the second scan FF in the scan chain by switching between the third selector and the fourth selector.
